# EUROPEAN PATENT SPECIFICATION

(11) **EP 3 352 543 B1**
(45) Date of publication and mention of the grant of the patent: **09.12.2020**
(21) Application number: 16846314.9
(22) Date of filing: 06.09.2016
(51) Int. Cl.: H05K 5/02, A45C 5/02, A45C 13/36, G06F 1/16, H04M 1/02, B29C 65/82

(54) **HOUSING**
GEHÄUSE
BOÎTIER

(30) Priority: 18.09.2015 JP 2015185986
(43) Date of publication of application: 25.07.2018
(73) Proprietor: Toray Industries, Inc., Tokyo 103-8666 (JP)
(72) Inventor: HONMA, Masato, Iyo-gun Ehime 791-3193 (JP); FUJIOKA, Takashi, Iyo-gun Ehime 791-3193 (JP)
(74) Representative: Kador & Partner PartG mbB
(86) International application number: PCT/JP2016/076123
(87) International publication number: WO 2017/047443

(56) References cited:
- EP-A1- 2 527 139
- WO-A1-2004/011248
- JP-A- 2000 283 369
- JP-A- 2001 185 865
- JP-A- 2001 185 865
- JP-A- 2005 317 942
- JP-A- 2006 205 436
- JP-A- 2006 205 436
- JP-A- 2006 297 927
- JP-A- 2013 074 043
- JP-A- 2013 074 043

## Description

### TECHNICAL FIELD

The present invention relates to a housing such as a housing in which an electronic device part is built (electronic device housing), and a housing such as an attache case or a carry case.

### BACKGROUND ART

In recent years, for reducing the thickness and weight of an electronic device, and preventing breakage of components in the electronic device, a housing has been required to have increased rigidity. Specifically, when the electronic device is held with one hand and operated with the other hand, when the electronic device is transported, or when a monitor or the like is opened or closed, a biased load is applied, and therefore a force acts in a torsion direction of a housing. Therefore, the housing is required to have high torsional rigidity. In addition, in order to reduce the cost of the housing, high productivity is required for the housing. Specifically, as the housing, one making it each to attach and assemble components is required. In view of such a background, many techniques for increasing the rigidity and productivity of a housing have been heretofore proposed. In addition, for electronic components that are packed in an electronic device, it is required to ensure that a user cannot easily touch and access the electronic components from the viewpoint of maintaining the electronic device and preventing accidents.

Specifically, Patent Document 1 discloses an invention for increasing the rigidity of an electric device cabinet structure which includes a resin lower case having upper and lower electric device mounting surfaces, and an upper case having a front wall overlapping the upper electric device mounting surface. Patent Document 2 discloses an invention for increasing the rigidity of an electronic device housing of by making the electronic device housing have a structure in which surfaces of two plates are selectively bonded and joined together. Patent Document 3 discloses an invention for increasing the rigidity of an electronic device housing by abutting the tip of a rib, which is formed on the inner surface of a first housing, against the inner surface of a second housing.

### PRIOR ART DOCUMENT

### PATENT DOCUMENTS

Patent Document 1: Japanese Patent Laid-open Publication No. 10-150280
Patent Document 2: Japanese Patent Laid-open Publication No. 8-288681
Patent Document 3: Japanese Patent Laid-open Publication No. 2011-22848.

Document JP2013074043 discloses a housing comprising a top cover, a bottom cover, and a reinforcing structure that is disposed in a space divided by the top cover and the bottom cover, and has an opening, the reinforcing structure being joined to the top cover or the bottom cover.

### SUMMARY OF THE INVENTION

### PROBLEMS TO BE SOLVED BY THE INVENTION

However, in the invention disclosed in Patent Document 1, the resin lower case and the electric device attachment surface in the lower stage are mechanically joined to each other using a screw. Thus, the invention disclosed in Patent Document 1 cannot meet market needs from the viewpoint of weight reduction. In addition, hole processing for screwing a screw is required, and therefore the strength of a member is reduced at a hole processing portion.

In the invention disclosed in Patent Document 2, the rigidity of the housing of an electronic device is increased by joining an inner plate to the whole surface of an outer plate using an adhesive. However, when a member is joined over the whole surface using an adhesive, many steps such as a pretreatment step, a coating step and a curing step are required, and a very long time is required for curing the adhesive, resulting in deterioration of productivity.

In addition, in the invention disclosed in Patent Document 3, the tip of the rib is in contact with only the inner surface of the housing. Thus, in the invention disclosed in Patent Document 3, if torsion occurs due to application of a heavy load to the housing, the tip of the rib relatively slips with respect to the inner surface of the housing, and therefore only a certain level of torsional deformation can be suppressed. In mechanical joining by a screw etc., or joining by engagement, the housing can be easily disassembled, so that it is not possible to suppress access to electronic components. In the case of joining by an adhesive, it is difficult to disassemble the housing, and thus access to electronic components can be suppressed, but joining by an adhesive hinders repair such as replacement of electronic components, or separation and disposal of electronic components.

As described above, in conventional techniques, it is not possible to improve the torsional rigidity and productivity of the housing while attaining thickness reduction and weight reduction. Thus, it is expected to provide a technique capable of improving the torsional rigidity and productivity of the housing while attaining thickness reduction and weight reduction. Further, a technique is expected which makes it difficult to electronic components by a user and which makes it possible to easily perform disassembly in the case of requiring repair and separation is required.

The present invention has been made in view of the above-described problems, and an object of the present invention to provide a housing which makes it difficult to access electronic components by a user, can be easily disassembled in the case of requiring repair and separation, and has improved torsional rigidity and productivity while having a reduced thickness and weight. The scope of the invention is limited by the appended claims.

### SOLUTIONS TO THE PROBLEMS

A housing according to the present invention includes: a top cover; a bottom cover; and a reinforcing structure that is disposed in a space divided by the top cover and the bottom cover, and has an opening, the reinforcing structure being joined to the top cover or the bottom cover. The reinforcing structure is joined to the bottom cover or the top cover with a pealing load of 60 N/cm² or more and 5000 N/cm² or less at 23°C and with a pealing load of less than 60 N/cm² at 200°C.

Optionally, the reinforcing structure is joined to the top cover or the bottom cover by thermal welding.

In the housing according to the present invention, a thermoplastic resin may be provided in or on a joining portion of at least one of the reinforcing structure and the top cover or the bottom cover to which the reinforcing structure is joined, and the reinforcing structure and the top cover or the bottom cover may be joined with the thermoplastic resin.

In the housing according to the present invention, the reinforcing structure, and the top cover or the bottom cover to which the reinforcing structure is joined may be formed of a fiber-reinforced composite material that is a cured product of a laminate of prepregs including a reinforcing fiber and a matrix resin, in the above-described invention.

In the housing according to the present invention, the reinforcing structure and the top cover or the bottom cover may be directly joined, in the above-described invention.

In the housing according to the present invention, the matrix resin may include a thermosetting resin, in the above-described invention.

In the housing according to the present invention, the reinforcing structure may include at least one material selected from the group consisting of a metal, a fiber-reinforced composite material with a glass fiber used as a reinforcing fiber, and a fiber-reinforced composite material with a carbon fiber used as a reinforcing fiber, and the top cover or the bottom cover which is joined to the reinforcing structure may include at least one material that is selected from the group, and is different from the material of the reinforcing structure, in the above-described invention.

In the housing according to the present invention, at least a part of the bottom cover or the top cover which is joined to the reinforcing structure may include a material having a volume resistivity of less than 1.0 × 10⁻² Ω•m, and the reinforcing structure includes a material having a volume resistivity of 1.0 × 10⁻² Ω•m or more, in the above-described invention.

In the housing according to the present invention, the reinforcing structure may include a plurality of components, in the above-described invention.

In the housing according to the present invention, the top cover and/or the bottom cover may include a plurality of components, in the above-described invention.

### EFFECTS OF THE INVENTION

The housing of the present invention makes it difficult to access electronic components by a user, can be easily disassembled in the case of requiring repair and separation, and has improved torsional rigidity and productivity while having a reduced thickness and weight.

### BRIEF DESCRIPTION OF THE DRAWINGS

Fig. 1 is a perspective view showing a configuration of a housing according to one embodiment of the present invention.
Fig. 2 is an exploded perspective view of the housing shown in Fig. 1.
Figs. 3 (a) to 3 (c) are sectional views showing one example of a configuration of a reinforcing structure.
Figs. 4(a) and 4(b) are sectional views showing one example of a configuration of the reinforcing structure shown in Fig. 2.
Figs. 5(a) and 5(b) are sectional views showing one example of a configuration of the reinforcing structure shown in Fig. 2.
Figs. 6(a) and 6(b) are sectional views showing one example of a configuration of a housing.
Figs. 7 (a) and 7(b) show a plan view and a sectional view showing a configuration of another reinforcing structure.
Figs. 8 (a) and 8(b) are schematic views for illustrating a torsional rigidity test method.
Fig. 9 is a schematic view for illustrating a deflection rigidity test method.
Fig. 10 is a schematic view for illustrating a peeling load test method.
Fig. 11 is a schematic view showing a configuration of a laminate.
Figs. 12(a) and 12(b) are schematic views for illustrating a press molding method.
Figs. 13(a) and 13(b) are schematic views for illustrating a press molding method.
Fig. 14 is a schematic view for illustrating a method for preparing a housing.
Fig. 15 is a schematic view for illustrating a method for preparing a housing.

### EMBODIMENTS OF THE INVENTION

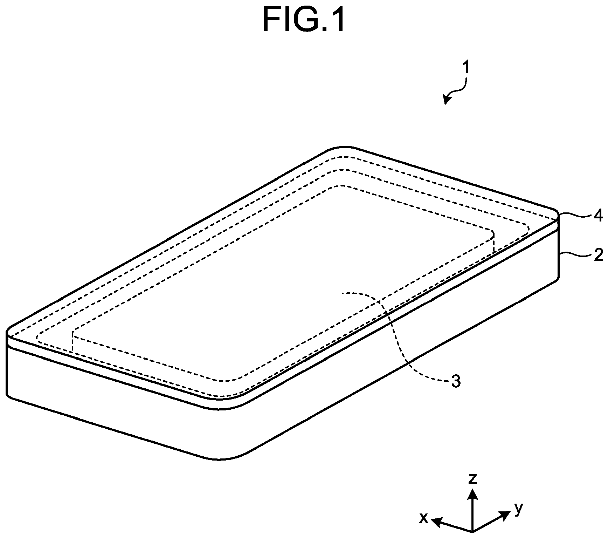

Hereinafter, a housing according to one embodiment of the present invention will be described with reference to Figs. 1 to 7. Examples of the application of the housing of the present invention may include attache cases, carry cases and electronic device housings in which an electronic device component is built, and more specific examples thereof include speakers, displays, HDDs, notebook personal computers, mobile phones, digital still cameras, PDAs, plasma displays, televisions, lighting systems, refrigerator and game machines. In particular, the housing is preferably used for clamshell-type personal computers and tablet-type personal computers which have high torsional rigidity and are required to be light and thin.

Fig. 1 is a perspective view showing a configuration of the housing according to the first embodiment of the present invention. As shown in Fig. 1, a housing 1 according to one embodiment of the present invention includes, as main components, a bottom cover 2 rectangular in plan view, a reinforcing structure 3 joined to the bottom cover 2 and having an opening, and a top cover 4 rectangular in plan view. In the following description, a direction parallel to short sides of the bottom cover 2 and the top cover 4 is defined as an x direction, a direction parallel to long sides of the bottom cover 2 and the top cover 4 is defined as a y direction, and a direction perpendicular to the x direction and the y direction is defined as a z direction (vertical direction).

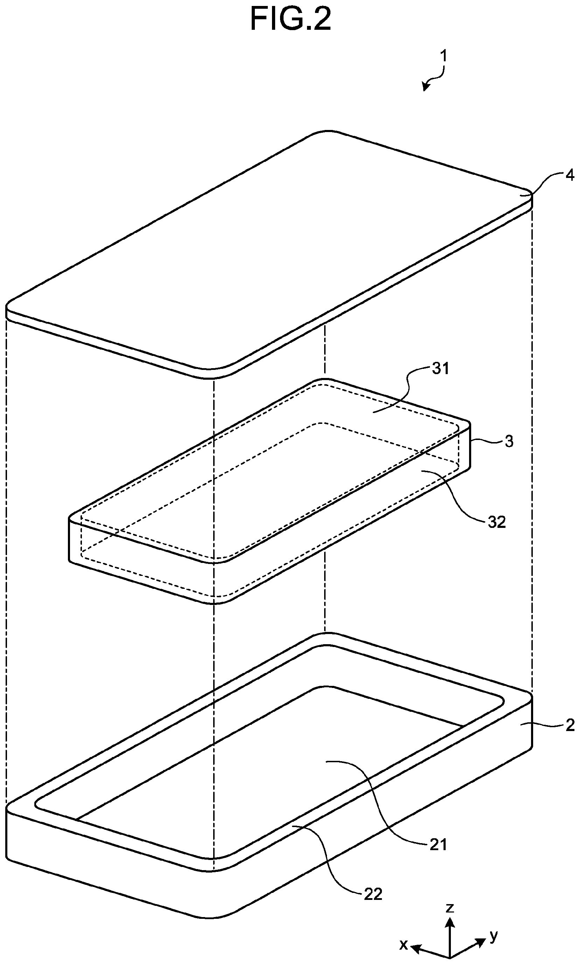

Fig. 2 is an exploded perspective view of the housing 1 shown in Fig. 1. As shown in Fig. 2, the bottom cover 2 includes a flat portion 21 parallel to an x-y plane and rectangular in plan view, and a rising wall member 22 erected in the positive direction of z from a rim of the flat portion 21. The thickness of a member that forms the bottom cover 2 is preferably within a range of 0.1 mm or more and 0.8 mm or less. In addition, the elastic modulus of the member that forms the bottom cover 2 is preferably within a range of 20 GPa or more and 120 GPa or less.

In addition, it is preferable that the bottom cover 2 is formed of any one of a metal material and a fiber-reinforced composite material, and the bottom cover 2 may be formed by combining these materials. From the viewpoint of exhibiting high torsional rigidity, the bottom cover 2 is preferably a seamless member formed of the same material. From the viewpoint of productivity, the flat portion 21 having a simple shape may be formed using the metal material and the fiber-reinforced composite material which have high dynamic properties, and the rising wall member 22 and a joining portion which have a complicated shape may be formed by injection molding etc. using a resin material excellent in moldability.

It is preferable to use a light metal material such as an aluminum alloy, a magnesium alloy or a titanium alloy as the metal material. Examples of the aluminum alloy may include A2017 and A2024 as Al-Cu systems, A3003 and A3004 as Al-Mn systems, A4032 as an Al-Si system, A5005, A5052 and A5083 as Al-Mg systems, A6061 and A6063 as Al-Mg-Si systems, and A7075 as an Al-Zn system. Examples of magnesium alloy may include AZ31, AZ61 and AZ91 as Mg-Al-Zn systems. Examples of the titanium alloy may include alloys containing palladium of grades 11 to 23, alloys containing cobalt and palladium, and Ti-6Al-4V corresponding to grade 50 (α alloy), grade 60 (α-β alloy) and grade 80 (β alloy).

As reinforcing fibers to be used in the fiber-reinforced composite material, fibers such as carbon fibers, glass fibers, aramid fibers, boron fibers, PBO fibers, high strength polyethylene fibers, alumina fibers and silicon carbide fibers can be used, and two or more of these fibers may be mixed, and used. These reinforcing fibers can be used as fiber structures such as long fibers aligned in one direction, single tows, woven fabrics, knits, nonwoven fabrics, mats and braided cords. Among them, carbon fibers are preferable from the viewpoint of dynamic properties, lightness and electromagnetic wave shielding property, and glass fibers are preferable from the viewpoint of dynamic properties and antenna properties (radio wave permeability).

Examples of the matrix resin that can be used include thermosetting resins such as epoxy resins, phenol resins, benzoxazine resins and unsaturated polyester resins, polyester-based resins such as polyethylene terephthalate (PET), polybutylene terephthalate (PBT), polytrimethylene terephthalate (PTT), polyethylene naphthalate and liquid crystal polyester, polyolefins such as polyethylene (PE), polypropylene (PP) and polybutylene, styrene-based resins, urethane resins, and thermosetting resins such as polyoxymethylene (POM), polyamide (PA), polycarbonate (PC), polymethyl methacrylate (PMMA), polyvinyl chloride (PVC), polyphenylene sulfide (PPS), polyphenylene ether (PPE), modified PPE, polyimide (PI), polyamideimide (PAI), polyether imide (PEI), polysulfone (PSU), modified PSU, polyether sulfone (PES), polyketone (PK), polyether ketone (PEK), polyether ether ketone (PEEK), polyether ketone ketone (PEKK), polyarylate (PAR), polyether nitrile (PEN), phenol-based resins, and phenoxy resins. From the viewpoint of productivity and dynamic characteristics, thermosetting resins are preferably used, and among them, epoxy resins are preferably used. From the viewpoint of moldability, thermoplastic resins are preferably used. Among them, polyamide resins are preferably used from the viewpoint of strength, polycarbonate resins are preferably used from the viewpoint of impact resistance, polypropylene resins are preferably used from the viewpoint of lightness, and polyphenylene sulfide resins are preferably used from the viewpoint of heat resistance. The resin may be used not only as a matrix resin of the fiber-reinforced composite material but also as the bottom cover, the top cover or the reinforcing structure which is composed of a resin itself.

In the present invention, it is preferable that a prepreg including the reinforcing fiber and matrix resin is used as a material of each member from the viewpoint of handling characteristics in lamination etc. From the viewpoints of high dynamic characteristics and design freedom, it is preferable to use unidirectional continuous fiber prepreg, and from the viewpoint of isotropic dynamic characteristics and moldability, it is preferable to use a fabric prepreg. In addition, the member may be composed of a laminate of these prepregs.

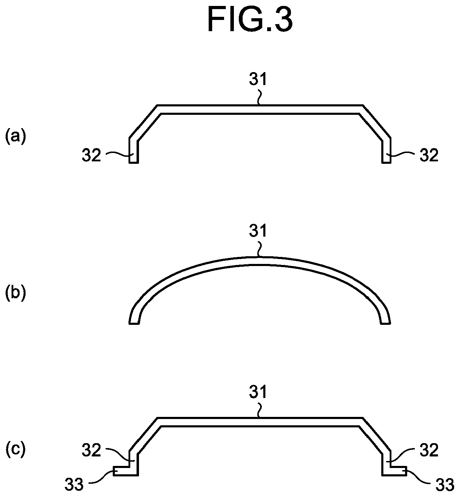

The reinforcing structure 3 is a reinforcing structure having an opening. Specifically, the reinforcing structure 3 includes a flat portion 31 parallel to an x-y plane and rectangular in plan view, and a rising wall member 32 erected in the negative direction of z from a rim of the flat portion 31. A surface of the flat portion 31, which faces the flat portion 21 of the bottom cover 2, is packed with an electronic device. The reinforcing structure 3 is joined to the bottom cover 2 with a hollow structure S1 formed between the flat portion 31 and the flat portion 21 of the bottom cover 2 by joining the rising wall member 32 to the flat portion 21 of the bottom cover 2. As used herein, the "reinforcing structure having an opening" refers to a shape having an opening in a part of the reinforcing structure, and may be a member having the flat portion 31, the rising wall member 32 and a surface connecting the flat portion 31 and the rising wall member 32 as shown in Figs. 3(a) and 3(b), or a member having a curved surface. In addition, one example of the reinforcing structure having an opening is a reinforcing structure having the flat portion 31, the rising wall member 32 erected on the rim of the flat portion, and the joining portion 33 extending from the rim of the rising wall member 32 as shown in Fig. 3(c), or having a curved portion, and a joining portion extending from a rim of the curved.

The area of the joining area in a plane parallel to the x-y plane is preferably within a range of 10 cm² or more and 100 cm² or less. Specifically, when the joining area is less than 10 cm², there arises the problem if a load that causes large deformation is applied to the housing 1, the reinforcing structure 3 is peeled from the bottom cover 2, and thus original torsional rigidity cannot be exhibited. On the other hand, when the joining area is larger than 100 cm², there arises the problem that the increase in joining area causes an increase in weight of the housing 1 and a decrease in volume of the hollow structure S1. Thus, the joining area is preferably within a range of 10 cm² or more and 100 cm² or less.

The maximum value of a distance h between the flat portion 31 of the reinforcing structure 3 and the flat portion 21 of the bottom cover 2 (height of the reinforcing structure 3 from the flat portion 21) is preferably within a range of 3 mm or more and 30 mm or less. In the present invention, the height h of the reinforcing structure 3 is one factor of exhibiting torsional rigidity. Thus, when the maximum value of the height h is less than 3 mm, there arises the problem that the effect of the rising wall member 32 is low in the housing 1, so that original torsional rigidity cannot be exhibited. On the other hand, when the maximum value of the height h is larger than 30 mm, there arises the problem that it is necessary to increase the thickness of the rising wall member 32, resulting in an increase in weight of the housing 1. Thus, the maximum value of the height h is preferably within a range of 3 mm or more and 30 mm or less.

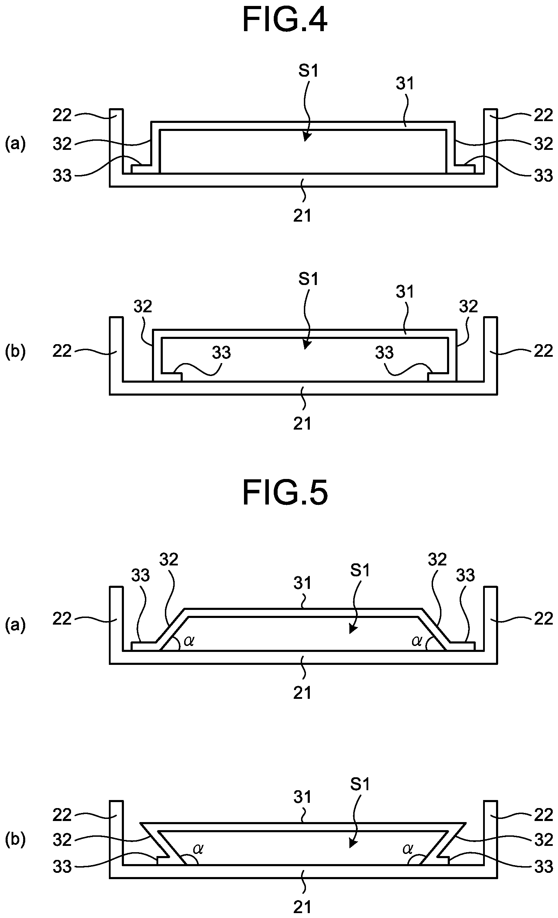

Figs. 4 and 5 are sectional views showing one example of a configuration of the reinforcing structure 3 shown in Fig. 2. The joining portion 33 may be provided so as to extend in an outward direction parallel to the x-y plane from the rim of the rising wall member 32 as shown in Fig. 4(a). In addition, the joining portion 33 may be provided so as to extend in an inward direction parallel to the x-y plane from the peripheral portion of the rising wall member 32 as shown in Fig. 4(b). In addition, it is preferable that the angle α of the rising wall member 32 with respect to the flat portion 21 of the bottom cover 2 (or the joining portion 33 of the reinforcing structure 3) is within a range of 45° or more and 135° or less as shown in Figs. 5 (a) and 5(b). Fig. 5 (a) shows a state in which the angle α of the rising wall member 32 is an acute angle, and Fig. 5(b) shows a state in which the angle α of the rising wall member 32 is an obtuse angle.

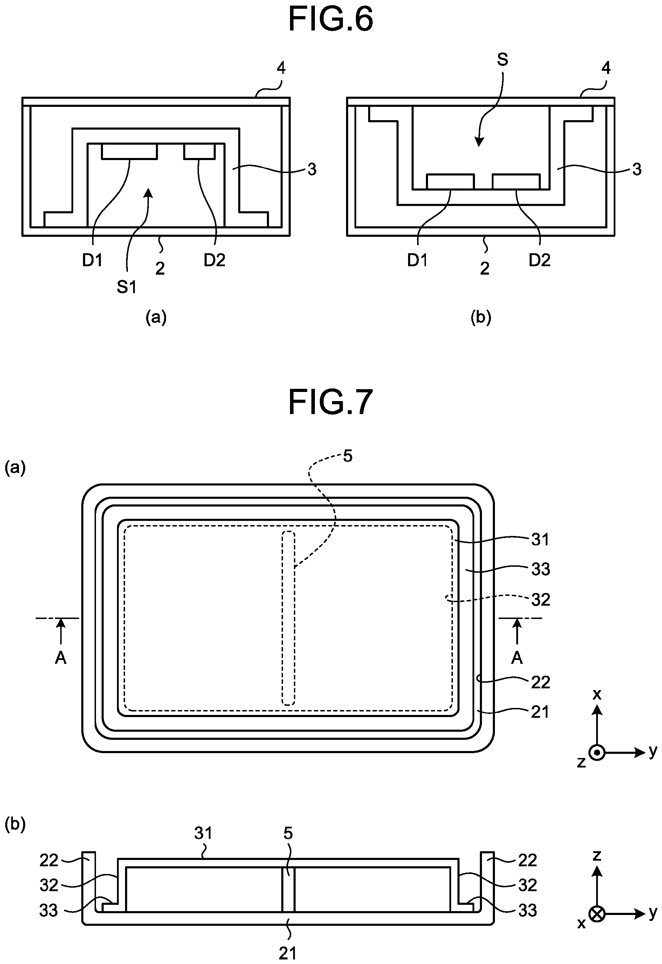

Fig. 6 is a sectional view showing one example of a configuration of the housing. As shown in Figs. 6 (a) and 6(b), heat generation members D1 and D2 are disposed in the hollow structure S1 formed by joining the reinforcing structure 3 and the bottom cover 2 or the top cover 4. It is preferable that the heat generation members D1 and D2 are disposed on a surface of the reinforcing structure 3 on the hollow structure S1 side. With this configuration, the distance between the bottom cover 2 touched by a user of an electronic device and the heat generation members D1 and D2 can be increased to suppress elevation of the temperature of the bottom cover 2. In this specification, the "heat generation member" means a component that generates heat as an electronic device is operated, and particularly refers to a component that causes temperature elevation by 10°C or more as the electronic device is operated. Examples of the heat generation member may include LEDs, capacitors, inverters, reactor elements, thermistor elements, power transistor elements, motors, CPUs, and electronic boards on which these elements are mounted.

Deflection rigidity may also be increased by disposing another in the hollow structure S1 formed between the flat portion 31 of the reinforcing structure 3 and the flat portion 21 of the bottom cover 2. Fig. 7(a) is a plan view showing a configuration of another reinforcing structure, and Fig. 7(b) is a sectional view taken along line A-A in Fig. 7(a). As shown in Figs. 7(a) and 7(b), another reinforcing structure 5 is a member disposed so as to extend in the x direction at the central part of the hollow structure S1 in the y direction, and is connected to the flat portion 21 of the bottom cover 2 and the flat portion 31 of the reinforcing structure 3. By integrating the flat portion 21 of the bottom cover 2 and the flat portion 31 of the reinforcing structure 3 with another reinforcing structure 5 interposed therebetween, the bottom cover 2 and the reinforcing structure 3 are deformed in synchronization with each other if a load is applied, and therefore the deflection rigidity of the housing 1 can be improved. In addition, the rising wall member 22 of the bottom cover 2 and the rising wall member 32 of the reinforcing structure 3 are integrated with another reinforcing structure 5, and thus the rising wall members of the bottom cover 2 and the reinforcing structure 3 are hardly deformed particularly inside direction of the housing 1, so that the torsional rigidity of the housing 1 can be improved.

As long as another reinforcing structure 5 is connected to the flat portion 21 of the bottom cover 2 and the flat portion 31 of the reinforcing structure 3, another reinforcing structure 5 may be a member disposed so as to extend in the y direction at the central part of the hollow structure S1 in the x direction, or a member disposed so as to extend in the diagonal direction of the hollow structure S1. In particular, it is preferable that another reinforcing structure 5 is disposed so as to pass through a position at which the amount of deflection of the flat portion 21 of the bottom cover 2 increases when a load is applied in the thickness direction, and a plurality of members may be disposed with the members crossing one another. In addition, it is preferable that another reinforcing structure 5 is formed of an impact absorbing material excellent in elasticity, such as a resin material having an elastomer or rubber component, or a gel, and accordingly, not only deflection rigidity but also an effect against impact can be exhibited.

In the present embodiment, a curved member may be used as the flat portion 31, resulting in omission of the rising wall member 32. In addition, from the viewpoint of increasing rigidity and effectively utilizing the space, an irregular shape may be formed on the flat portion 31. In the present embodiment, the reinforcing structure 3 is joined to the bottom cover 2, but the reinforcing structure 3 may be joined to the top cover 4 to form the hollow structure S1 between the flat portion 31 of the reinforcing structure 3 and the top cover 4.

In the present embodiment, the joining portion 33 is formed on all of the four rising wall members 32 formed on respective sides of the flat portion 31, but the joining portion 33 may be formed on at least one of the four rising wall members 32. Alternatively, the joining portion 33 may be formed on two or more adjacent rising wall members 32 among the four rising wall members 32. In addition, the area of the joining portion 33 formed on one rising wall member 32 is preferably 1 cm² or more. In addition, the thickness of the member that forms the reinforcing structure 3 is preferably within a range of 0.3 mm or more and 1.0 mm or less from the viewpoint of reducing the weight and thickness of the housing. In addition, the elastic modulus of the member that forms the reinforcing structure 3 is preferably within a range of 20 GPa or more and 120 GPa or less.

In addition, it is preferable that the reinforcing structure 3 is formed of any one of the above-described metal material and fiber-reinforced composite material, and the material can be selected according to the purpose of the reinforcing structure 3. That is, it is preferable to use a metal material or fiber-reinforced composite material having a high elastic modulus from the viewpoint of exhibiting a high reinforcing effect, it is preferable to use a metal material having a high thermal conductivity from the viewpoint of heat dissipation, it is preferable to use a non-conductive material such as a resin or a glass fiber-reinforced composite material from the viewpoint of exhibiting radio wave permeability (antenna property), and it is preferable to use a conductive material such as a metal material or a carbon fiber-reinforced composite material from the viewpoint of exhibiting electromagnetic wave shielding property (radio wave shielding property).

It is preferable that the reinforcing structure 3 and the top cover 4 or the bottom cover 2 which is joined to the reinforcing structure 3 are composed of different materials. With this configuration, it is possible to impart a function to each member, and design freedom is improved as a configuration of the housing. In particular, it is preferable that the reinforcing structure 3 includes at least one material selected from the group consisting of a metal, a fiber-reinforced composite material with a glass fiber used as a reinforcing fiber, and a fiber-reinforced composite material with a carbon fiber used as a reinforcing fiber, and the bottom cover 2 or the top cover 4 which is joined to the reinforcing structure 3 includes at least one material that is selected from the foregoing group, and is different from the material of the reinforcing structure 3.

Further, it is preferable that at least a part of the bottom cover 2 or the top cover 4 which is joined to the reinforcing structure 3 includes a material having a volume resistivity of less than 1.0 × 10⁻² Ω•m, and the reinforcing structure 3 includes a material having a volume resistivity of 1.0 × 10⁻² Ω•m or more. With this configuration, a housing can be obtained which is capable of blocking an electromagnetic wave emitted to the outside from an electronic component, and transmitting (sending and receiving) a radio wave required for communication. Further, when the reinforcing structure 3 is formed of a fiber-reinforced composite material, it is preferable that the reinforcing structure 3 is composed of a laminate of continuous fiber prepregs. In addition, the ratio of the linear expansion coefficient of the reinforcing structure 3 to the linear expansion coefficient of the bottom cover 2 to which the reinforcing structure 3 is joined is preferably within a range of 0.1 or more and 10 or less.

In addition, it is preferable that the reinforcing structure 3 is joined to the flat portion 21 of the bottom cover 2 by thermal welding. The peeling load at 23°C is preferably within a range of 60 N/cm² or more and 5000 N/cm² or less, more preferably within a range of 100 N/cm² or more and 5000 N/cm² or less. Examples of the thermal welding method may include an insert injection method, an outsert injection method, a vibration welding method, an ultrasonic welding method, a laser welding method and a hot plate welding method. Here, it is preferable that the bonding surface between the reinforcing structure 3 and the flat portion 21 has a peeling load of less than 60 N/cm² at 200°C. The peeling load at 200°C is more preferably 30 N/cm² or less.

In addition, this peeling load is preferably less than 60 N/cm² at 180°C, and it is preferable from the viewpoint of disassembling adhesive that the peeling load can be easily peeled off in a lower temperature range. However, when the disassembling temperature lowers, the reinforcing structure may be peeled off temperature elevation associated with operation of an electronic component or depending on the temperature of a use environment in use as a housing. Therefore, it is preferable that in the temperature range where the housing is used, the reinforcing structure is joined with high bonding strength, and in the disassembling temperature range, the reinforcing structure can be easily peeled off. Thus, the peeling load at 80°C is more preferably within a range of 60 N/cm² or more and 5000 N/cm² or less.

With respect to the present embodiment, it is possible to perform firm joining by mechanical joining with a screw or the like, or by an adhesive, but mechanical joining is not preferable because a user can easily perform disassembly, and easily access electronic components packed in an electronic device. In addition, in the case of an adhesive, once joining is performed, peeling is difficult, and therefore it is impossible to meet a user's request when repair or the like is necessary.

The peeling load at 200°C is preferably as low as possible, and most preferably 10 N/cm² or less. Since the peeling load at 200°C is preferably as low as possible, the lower limit thereof is not particularly limited, and is preferably 0 N/cm² or more, but the peeling load at 200°C is more preferably 1 N/cm² or more because when it is excessively low, handling characteristics may be deteriorated. With this configuration, disassembling bondability that makes it possible to easily remove the reinforcing structure 3 can be exhibited, so that repair and recycling of an electronic device can be facilitated. In addition, it is preferable that the reinforcing structure 3, and the bottom cover 2 to which the reinforcing structure 3 is joined are formed of a fiber-reinforced composite material, a thermoplastic resin is provided in or on a joining portion of at least one of the reinforcing structure 3 and the bottom cover 2, and the reinforcing structure 3 and the bottom cover 2 are joined with the thermoplastic resin.

As a method for providing a thermoplastic resin on the joining portion, mention is made of a method in which using a fiber-reinforced sheet (prepreg sheet) including a thermoplastic resin as a matrix resin, molding is performed to obtain the reinforcing structure 3, and the bottom cover 2 or the top cover 4 to which the reinforcing structure 3 is joined. A molded product obtained by this method is preferable because a thermoplastic resin is present on a surface of the molded product at a high ratio, and therefore it is possible to secure a wide bonding area in joining, leading to an increase in selection freedom of a joining site. From the viewpoint of the dynamic characteristics of the members, a fiber-reinforced composite material including a thermosetting resin as a matrix resin is preferable, and as a method for providing a thermoplastic resin on such a member, a mention is made of a method in which a molten material obtained by heating and melting a thermoplastic resin or a solution obtained by dissolving a thermoplastic resin in a solvent is applied to provide a thermoplastic resin on the fiber-reinforced composite material. In addition, a mention may be made of, for example, a method in which in molding and curing of a fiber-reinforced sheet (prepreg sheet) including a thermosetting resin as a matrix resin, a laminate in which a film or nonwoven fabric composed of a thermoplastic resin is laminated on a surface is molded under heat and pressure on the outermost layer of the fiber-reinforced sheet (prepreg sheet).

In addition, it is preferable that the reinforcing structure 3 and the bottom cover 2 or the top cover 4 are joined directly. When a fiber-reinforced composite material having a thermoplastic resin is used for the reinforcing structure 3 and/or the joining portion of the bottom cover 2 or the top cover 4 that is bonded to the reinforcing structure 3, it is not necessary to use an adhesive agent other than the members, and the members can be joined directly, so that an increase in weight of the housing 1 can be suppressed. A suitable method for directly joining the reinforcing structure 3 and the bottom cover 2 or the top cover 4 is a method using a laminate, in which a film or nonwoven fabric composed of a thermoplastic resin is laminated on a surface, for the outermost layer of a fiber-reinforced sheet (prepreg sheet) including a thermosetting resin as a matrix resin, and the thermoplastic resin used here can also be selected from the group of thermoplastic resins exemplified as the matrix resin.

Preferably, a thermoplastic resin is selected which has a melting point lower than the molding temperature at which a fiber-reinforced sheet (prepreg sheet) with the matrix resin composed of a thermosetting resin is molded and cured. The lower limit of the melting point of the thermoplastic resin is not particularly limited, but it is preferably 80°C or higher, more preferably 100°C or higher from the viewpoint of exhibiting heat resistance in application of the housing of the present invention to an electronic device. In addition, the form of the thermoplastic resin is not particularly limited, and examples thereof include forms of films, continuous fibers, woven fabrics, particles, nonwoven fabrics and the like, but from the viewpoint of handling characteristics during molding operation, forms of films and nonwoven fabrics are preferable. By selecting such a resin, the thermoplastic resin is melted during molding, and the thermoplastic resin is formed while spreading like a film over a surface of a molded product, so that the bonding area increases during joining, or the reinforcing fibers of the fiber-reinforced sheet are impregnated with the thermoplastic resin to form a strong thermoplastic resin layer, so that high peeling strength can be exhibited. The thermoplastic resin may be provided on at least one of the reinforcing structure 3 obtained in the above-mentioned method and the bottom cover 2 and the top cover 4 joined to the reinforcing structure 3, but it is preferable that the thermoplastic resin is provided on the joining members of both the members to be joined. In addition, it is preferable that substantially the same thermoplastic resin is selected as thermoplastic resins to be provided.

In this specification, the "disassembling adhesive" means that the reinforcing structure 3 can be not only easily removed, but also re-bonded, and in re-bonding, the thermoplastic resin may be provided, but it is preferable that the reinforcing structure can be re-bonded without increasing the weight of the thermoplastic resin or the like. In addition, the peeling load in re-bonding is preferably 50% or more, more preferably 70% or more, of the original peeling load. The disassembling adhesive in the present invention can be attained by applying to a joining technique such characteristics of a thermoplastic resin that the resin is melted by heating to reduce dynamic characteristics, and the resin is solidified by cooling or at normal temperature to exhibit high dynamic characteristics specific to the resin.

In addition, a hole can be formed in each of the flat portion 31 and the rising wall member 32 of the reinforcing structure 3 within the bounds of not considerably reducing torsional rigidity in the present invention. With such a structure, it is possible to dispose a wiring cable for connecting an electronic component built in the hollow structure S1 to an electronic component disposed in a space other than the hollow structure S1 divided by the bottom cover 2 and the top cover 4, and a display, a key board and so on which correspond to the top cover 4. From the viewpoint of heat dissipation, it is preferable that the hole is disposed to so as to improve the flow of air, e.g. the hole is formed on the opposed rising wall member 32. The area of the holes is preferably 30% or less of the surface area of the reinforcing structure 3, and is more desirably 15% or less of the surface area of the reinforcing structure 3 from the viewpoint of torsional rigidity.

The top cover 4 is joined to the rim of the rising wall member 22 of the bottom cover 2. In Fig. 1, the top cover 4 has a smooth plate shape, but may have a plate shape having a curved surface or irregularities. The material and shape of the top cover 4 may be the same as those of the bottom cover 2, and a plurality of reinforcing structures may be disposed and joined in a space by dividing the reinforcing structure 3 by the bottom cover 2 and the top cover 4. With such a configuration, the housing 1 having high rigidity on either of surfaces thereof can be obtained. In addition, the top cover 4 may be an electronic component such as a liquid crystal display or a keyboard, and with such a configuration, application to a clamshell-type personal computer or a tablet-type personal computer is possible.

As is evident from the above description, the housing 1 according to one embodiment of the present invention includes: the top cover 4; the bottom cover 2 having the rising wall member 22 erected toward the top cover 4 and joined to the top cover 4 at the rim; and the reinforcing structure 3 that is disposed in the hollow structure S1 divided by the top cover 4 and the bottom cover 2, and has an opening, the reinforcing structure 3 being joined to the bottom cover 2. The reinforcing structure 3 is (1) joined to the bottom cover 2 or the top cover 4 with a pealing load of 60 N/cm² or more and 5000 N/cm² or less at 23°C and with a pealing load of less than 60 N/cm² at 200°C, and/or (2) joined to the top cover 4 or the bottom cover 2 by thermal welding. Accordingly, access to electronic components by a user is made difficult, and disassembly can be easily performed in the case of requiring repair and separation, and torsional rigidity and productivity can be improved while thickness reduction and weight reduction are attained.

The hollow structure S1 may be formed by forming the reinforcing structure 3 from a member having an opening, and joining the reinforcing structure 3 to the bottom cover 2 or the top cover 4. Here, it is preferable that the projected area of the reinforcing structure 3 in a direction of the joined bottom cover 2 or top cover 4 is adjusted to fall within a range of 60% or more and 95% or less of the projected area of the joined bottom cover 2 or top cover 4. The disposed position of the reinforcing structure 3 is not particularly limited, but it is preferable that the reinforcing structure 3 is positioned equally from the center position of the bottom cover 2 or the top cover 4, and by disposing the reinforcing structure 3 in this manner, torsional rigidity in an x direction or a y direction can be made isotropic. From the viewpoint of effectively utilizing a space other than the hollow structure S1, in the space divided by the bottom cover 2 and the top cover 4, the reinforcing structure 3 may be placed on any one of the bottom cover 2 or the top cover 4.

Specifically, when the projected area of the reinforcing structure 3 is less than 60% of the area of the bottom cover 2 or the top cover 4 to which the reinforcing structure 3 is joined, there arises the problem that the rising wall member that is one factor of exhibiting torsional rigidity in the present invention is formed at a position close to the center position of the bottom cover 2 or the top cover 4, so that original torsional rigidity cannot be exhibited. On the other hand, when the projected area S of the reinforcing structure 3 is more than 95% of the area of the bottom cover 2 or the top cover 4 to which the reinforcing structure 3 is joined, high torsional rigidity can be exhibited, but there arises the problem that the space other than the hollow structure S1 becomes small, and therefore it is difficult to dispose electronic components and wiring and the like for forming an electronic device, so that application as a housing is difficult. Thus, the projected area in a direction of the joined bottom cover 2 or top cover 4 is preferably within a range of 60% or more and 95% or less of the area of the joined bottom cover 2 or top cover 4.

Here, the shape of the projected surface of the reinforcing structure 3, i.e. the shape of the flat portion 31 is not particularly limited, and may be not only a rectangular shape, but also a circular shape or a polygonal shape, and from the viewpoint of exhibiting high deflection rigidity, a shape conforming to the shape of the bottom cover 2 and/or the top cover 4 is preferable. Specifically, the shape of the projected surface of the reinforcing structure 3 is preferably a rectangular shape. In addition, from the viewpoint of effectively utilizing the hollow structure S1 and a space other than the hollow structure S1, the shape of the projected surface of the reinforcing structure 3 is preferably a shape conforming to the shape of an electronic component to be packed. In addition, from the viewpoint of exhibiting isotropic rigidity against any load, the shape of the projected surface of the reinforcing structure 3 is preferably a shape that is symmetric with respect to an axis in the x direction and/or the y direction.

In addition, when the hollow structure S1 is formed by forming the reinforcing structure 3 from a member having the opening, and joining the reinforcing structure 3 to the bottom cover 2 or the top cover 4, the volume of the hollow structure S1 formed by the reinforcing structure 3 in the bottom cover 2 is preferably within a range of 55% or more and 95% or less of the volume of the space divided by the bottom cover 2 and the top cover 4. Specifically, when the volume of the hollow structure S1 is less than 55% of the volume of the space divided by the bottom cover 2 and the top cover 4, there arises the problem that the height of the rising wall member that is one factor exhibiting torsional rigidity in the present invention is low and/or the projected area of the reinforcing structure 3 is small, so that original torsional rigidity cannot be exhibited. On the other hand, when the volume of the hollow structure S1 is more than 95% of the volume of the space divided by the bottom cover 2 and the top cover 4, high torsional rigidity can be exhibited, but there arises the problem that the space other than the hollow structure S1 becomes small, and thus it is difficult to dispose electronic components and wiring and the like for forming an electronic device, so that application as a housing is difficult. Thus, the volume of the hollow structure S1 is preferably within a range of 55% or more and 95% or less of the volume of the space divided by the bottom cover 2 and the top cover 4.

In the present embodiment, the reinforcing structure 3 includes one component, but the reinforcing structure 3 may include a plurality of components. Similarly, the bottom cover 2 and the top cover 4 include one component, but the bottom cover 2 and/or the top cover 4 may include a plurality of components. With regard to the reinforcing structure including a plurality of components, the bottom cover including a plurality of components, and the top cover including a plurality of components, the method for joining a plurality of components for forming the reinforcing structure 3, the bottom cover 2 and the top cover 4 is not particularly limited. Examples of the method for joining a plurality of components include a method components are provided with holes, and fastened using screws, rivets and the like, or a method in which components shapes so that they can be mutually fitted are fitted and joined. Other methods for joining a plurality of components include a method in which in which an adhesive is applied to join components, and a method in which components are joined by thermal welding with a thermoplastic resin interposed between the components. Examples of the thermal welding method may include an insert injection method, an outsert injection method, a vibration welding method, an ultrasonic welding method, a laser welding method and a hot plate welding method.

While embodiments of the invention made by the present inventors have been described above, the present invention is not limited by descriptions and drawings constituting a part of the disclosure of the present invention with the embodiments . That is, other embodiments, examples, operational techniques and the like that are made by those skilled in the art on the basis of the embodiments are all included in the scope of the present invention.

### Examples

Hereinafter, the present invention will be described in detail by way of examples. However, the present invention is not limited to the following examples.

### <Evaluation and Measurement Methods>

### (1) Torsional Rigidity Test

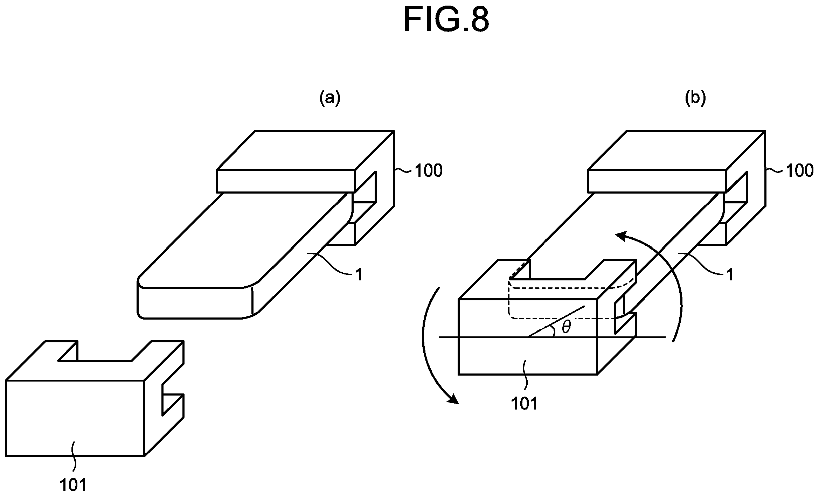

A housing 1 was fixed in a tester in such a manner that one side of the housing 1 was fixed by a U-shaped fixing tool 100, and the other side opposed to the fixed side was held by a support tool 101 as shown in Fig. 8(a), the displacement amount of the housing 1 was then measured when a load of 50 N was applied with a change rate set to 1°/min at an angle θ as shown in Fig. 8(b), and the measured value was defined as a torsional rigidity value of the housing.

### (2) Deflection Rigidity Test

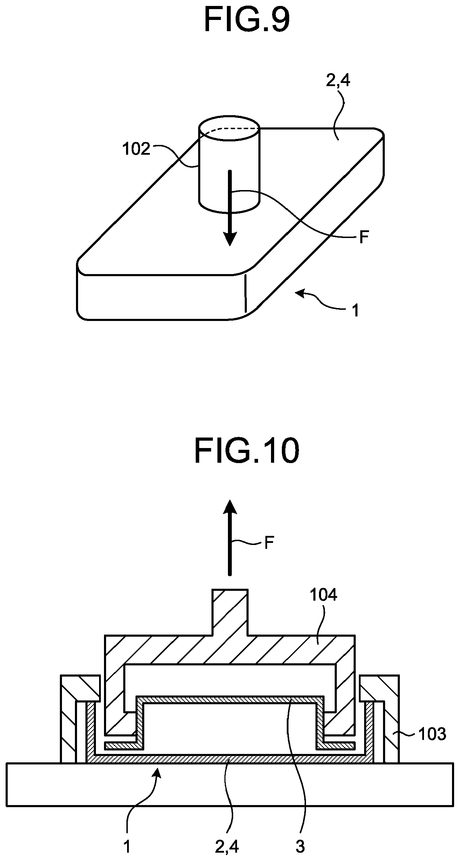

As shown in Fig. 9, the housing 1 was installed in a tester in such a manner that it was able to apply a tensile load F from the side of a bottom cover 2 or a top cover 4 to which a reinforcing structure was joined. "Instron" (registered trademark) Universal Tester Model 4201 (manufactured by Instron Co., Ltd.) was used as a tester. The deflection amount of the bottom cover 2 or the top cover 4 was measured when a load of 100 N was applied with the housing 1 pressed at the center position at a cross head speed of 1.0 mm/min using an indenter 102 having a diameter of 20 mm, and the measured value was defined as a deflection rigidity value.

### (3) Evaluation of Flexural Modulus

In accordance with the specifications in ASTM D-790, the flexural moduli of materials to be used for the reinforcing structure 3, the bottom cover 2 and the top cover 4 were evaluated. From each of members obtained in examples and comparative examples, a bending test piece having a width of 25 ± 0.2 mm with a length set to span L + 20 ± 1 mm so that the thickness D and the span L satisfied the relationship of L/D = 16 was cut for the four directions: 0°, + 45°, -45° and 90° directions where a certain direction was set to the 0° direction. In this way, test pieces were prepared. The number of measurements (n) in each direction was 5, and the average value of all measured values (n = 20) was defined as a flexural modulus. "Instron" (registered trademark) Universal Tester Model 4201 (manufactured by Instron Co., Ltd.) was used as a tester, a three-point bending test tool (indenter diameter: 10 mm, fulcrum diameter: 10 mm) was used, the support span was set to 16 times of the thickness of the test piece, and the bending elastic modulus was measured. The test was conducted under the following conditions: the moisture content of the test piece was 0.1 mass% or less, the atmospheric temperature was 23°C, and the humidity was 50% by mass.

### (4) Peeling Load Test of Reinforcing Structure (23°C and 200°C)

The peeling load of the reinforcing structure was evaluated in accordance with "Method for Testing Tensile Bonding Strength of Adhesive" specified in JIS K6849 (1994). As test pieces in this test, housings obtained in examples and comparative examples were used. Here, for measuring the peeling strength of the reinforcing structure, evaluation was performed in a state in which there was not a top cover or bottom cover to which the reinforcing structure was not joined (before the reinforcing structure was joined). Specifically, as shown in Fig. 10, the bottom cover 2 or the top cover 4 of the housing 1 was fixed by a fixing tool 103, and the reinforcing structure 3 was fixed by a tensile tool 104. A tensile load F was applied while each member was fixed, and evaluation was performed until the reinforcing structure 3 was peeled off, or the tensile tool 104 was detached from the reinforcing structure 3. The bonding area here was calculated by measuring the width and length of the joining surface of the reinforcing structure 3 before joining. When joining was partially performed, the areas thereof were measured, and summed to determine a joining area. The peeling load of the reinforcing structure 3 was calculated from the resulting tensile load value and joining area. For the peeling load of the reinforcing structure 3 at 200°C, the housing 1 was placed in a thermostat together with the fixing tool, and the atmospheric temperature in the thermostat was elevated to 200°C. After elevation of the temperature, this state was maintained for 10 minutes, and a tensile load was then applied in the same manner as in the peeling load test of the reinforcing structure 3, and evaluation was performed.

### (5) Measurement of Volume Resistivity

A test piece was cut out from each member, and dried into an absolutely dry state (moisture content: 0.1% or less), and the width, the length and the thickness of the test piece were then measured using a caliper or a micrometer. After the measurement, a conductive paste (DOTITE manufactured by Fujikura Kasei Co. Ltd.) was applied to cross-sections at both ends of the test piece, the conductive paste was sufficiently dried, the both ends of the test piece were then press-bonded to electrodes, and an electric resistance value between the electrodes was measured by a digital multimeter (manufactured by FLUKE Corporation). A value obtained by subtracting the contact resistance values of a measurement device, a tool and so on from the measured electric resistance value was multiplied by the area of a conductive paste-coated surface, and the obtained value was divided by the length of the test piece to determine a volume resistivity value (unit: Ω•m).

### <Materials Used>

Materials used for evaluation are shown below.

### [Material 1]

"TORAYCA" Prepreg P3252S-12 (manufactured by Toray Industries, Inc.) was provided as material 1. The properties of material 1 are shown in Table 1 below.

### [Material 2]

SCF 183 EP-BL 3 manufactured by Super Resin Industry Co., Ltd. was provided as material 2. The properties of material 2 are shown in Table 1 below.

### [Material 3]

An aluminum alloy A5052 was provided as material 3. The properties of material 3 are shown in Table 1 below.

### [Material 4]

A magnesium alloy AZ31 was provided as material 4. The properties of material 4 are shown in Table 1 below.

### [Material 5]

A titanium alloy Ti-6 Al-4V was provided as material 5. The properties of material 5 are shown in Table 1 below.

### [Material 6]

Using a master batch including 90% by mass of a polyamide 6 resin ("AMILAN" (registered trademark) CM1021T manufactured by Toray Industries, Inc.) and 10% by mass of a polyamide terpolymer resin composed of polyamide 6/66/610 ("AMILAN" (registered trademark) CM4000 manufactured by Toray Industries, Inc.), a thermoplastic resin film having a basis weight of 124 g/m² was prepared, and provided as material 6. The properties of material 6 are shown in Table 1 below.

**[Table 1]**

| | | Material 1 | Material 2 | Material 3 | Material 4 | Material 5 | Material 6 |
|---|---|---|---|---|---|---|---|
| Material | - | CFRP | GFRP | Al alloy | Mg alloy | Ti alloy | Ny resin |
| Elastic modulus | GPa | 60 | 25 | 70 | 45 | 113 | 3.5 |
| Linear expansion coefficient | 10⁻⁶/°C | 0.3 | 7 | 23.6 | 26 | 8.2 | 83 |
| Thermal conductivit y | W/m•K | 3.0 | 0.3 | 236.0 | 159.0 | 22.0 | 0.3 |
| Volume resistivity | Ω•m | 2 × 10⁻⁴ | 1 × 10¹² | 3 × 10⁻⁶ | 4 × 10⁻⁶ | 4 × 10⁻⁵ | 1 × 10¹² |

### (Example 1)

### Example 1-(1): Preparation of Bottom Cover

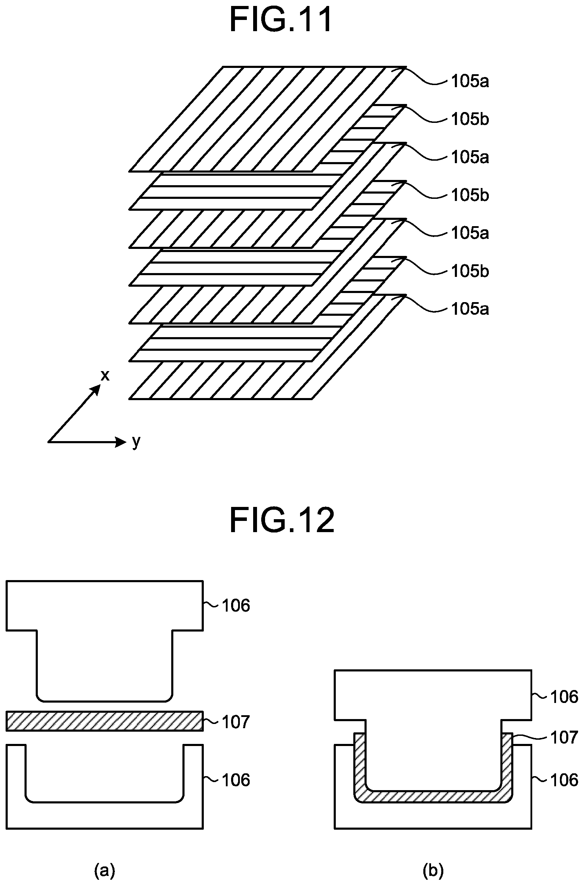

Seven sheets having a predetermined size were cut from material 1. Among them, four sheets were cut in such a manner that the fiber direction of a prepreg was parallel to a longitudinal direction (x direction in Fig. 1), and the other three sheets were cut in such a manner that the fiber direction was parallel to a lateral direction (y direction in Fig. 1). In this example, the lateral direction (y direction) was set to 0°, and as shown in Fig. 11, a laminate including seven prepreg sheets was prepared in such a manner that prepreg sheets 105a with the fiber direction set to 90° and prepreg sheets 105b with the fiber direction set to 0° were symmetrically laminated.

Here, a press molding apparatus and a pair of molds 106 as shown in Fig. 12(a) were used, and the resulting laminate 107 was disposed in a pair of molds 106. Here, the heating platen temperature of the press molding apparatus was set to 150°C, and as shown in Fig. 12(b), the molds 106 were moved, and the laminate was pressurized with the molding pressure kept at 1.0 MPa. After 30 minutes, the molds 106 were opened, and the molded article was removed from the molds 106. Trimming was performed so that the rising wall of the resulting molded article had a desired height, thereby obtaining a bottom cover.

### Example 1-(2): Preparation of Top Cover

Except that molds configured to prepare a molded article having a smooth shape were used, the same procedure as in Example 1-(1) was carried out to obtain a molded article. Trimming was performed so that the resulting molded article had a desired size, thereby obtaining a top cover.

### Example 1-(3): Preparation of Reinforcing Structure

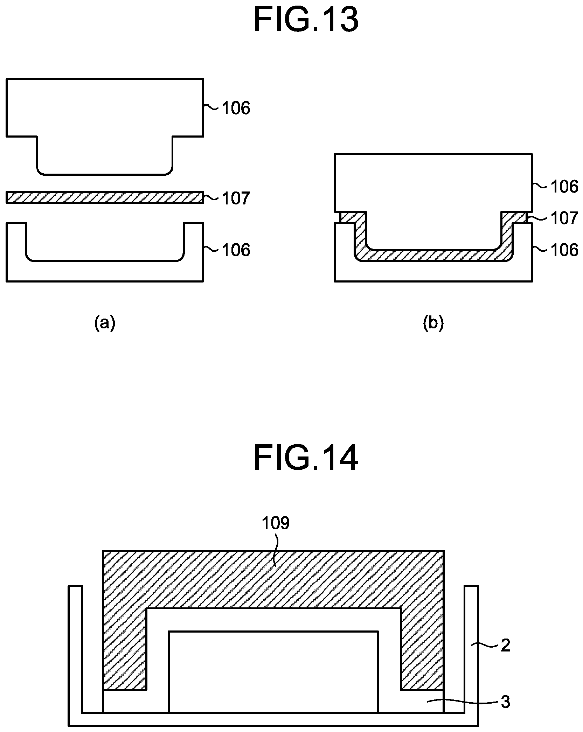

Except that molds 106 as shown in Fig. 13 were used, the same procedure as in Example 1-(1) was carried out to obtain a molded article. Trimming was performed so that the joining surface of the resulting molded article had a desired width, thereby obtaining a reinforcing structure.

### Example 1-(4): Preparation of Housing

A hot melt resin (HM712 manufactured by Cemedine Co., Ltd.) melted by a hot melt applicator at 140°C was applied to the joining pat of each member obtained in Examples 1-(1) to 1-(3), a reinforcing structure was superposed thereon, a weight was placed on the reinforcing structure, and this state was kept for 3 minutes. The molding conditions and evaluation results in Example 1 are shown in Table 2 below.

### (Example 2)

### Examples 2- (1) to 2- (3) : Preparation of Bottom Cover, Top Cover and Reinforcing Structure

A film composed of a polyamide copolymer ("AMILAN" (registered trademark) CM8000 manufactured by Toray Industries, Inc.) and having a thickness of 50 µm was laminated on a surface joined to each member, thereby obtaining a laminate. Except that the resulting laminate was used, the same procedure as in Examples 1-(1) to 1-(3) was carried out to obtain each member.

### Example 2-(4): Preparation of Housing

The reinforcing structure obtained in Example 2-(3) and the bottom cover obtained in Example 2-(1) were superposed on each other in joined form, a joining tool 109 as shown in Fig. 14 was provided, and the joined bottom cover and reinforcing structure were disposed, and heated and pressurized in a press molding apparatus set so that the joining tool 109 had a surface temperature of 180°C. After 1 minute, the bottom cover 2, the reinforcing structure 3 and the joining tool 109 were taken out from the press molding apparatus, and cooled. After 5 minutes, the joining tool 109 was removed to obtain an integrated product of the bottom cover 2 and the reinforcing structure 3. Similarly, the top cover obtained in Example 2- (2) was thermally welded and joined to the bottom cover. The molding conditions and evaluation results in Example 2 are shown in Table 2 below.

### (Example 3)

As another reinforcing structure, 25 sheets of material 1 were laminated so as to have a thickness of 3 mm with 0° prepreg sheets and 90° prepreg sheets being symmetrically laminated in an alternate manner. In the same manner as in Example 1-(1), the laminate was heated and pressurized by a press molding apparatus to obtain a molded article. The resulting molded article was processed so as to have a height of 7.2 mm, thereby obtaining another reinforcing structure having a size as shown in Table 2. The resulting another reinforcing structure was disposed as shown in Fig. 7, and joined by an adhesive, and subsequently the same procedure as in Examples 2-(1) to 2-(4) to obtain a housing. The molding conditions and evaluation results in Example 3 are shown in Table 2 below.

### (Example 4)

Except that a reinforcing structure having a size as described in Table 2 was molded and used, the same procedure as in Examples 2-(1) to 2-(4) was carried out to obtain a housing. The molding conditions and evaluation results in Example 4 are shown in Table 2 below.

### (Example 5)

Except that as the bottom cover, a material as described in Table 3 was used, the heating platen temperature was 220°C, and the molding pressure was 10 MPa, the same procedure as in Example 2 was carried out to obtain a housing. The molding conditions and evaluation results in Example 5 are shown in Table 3 below.

### (Example 6)

Except that as the bottom cover, a material as described in Table 3 was used, the heating platen temperature was 200°C, and the molding pressure was 10 MPa, the same procedure as in Example 2 was carried out to obtain a housing. The molding conditions and evaluation results in Example 6 are shown in Table 3 below.

### (Example 7)

Except that as the bottom cover, a material as described in Table 3 was used, the heating platen temperature was 240°C, and the molding pressure was 10 MPa, the same procedure as in Example 2 was carried out to obtain a housing. The molding conditions and evaluation results in Example 7 are shown in Table 3 below.

### (Example 8)

Except that a bottom cover with a size and a material as described in Table 3 was molded and used, the same procedure as in Example 2 was carried out to obtain a housing. The molding conditions and evaluation results in Example 8 are shown in Table 3 below.

### (Example 9)

Except that a reinforcing structure with a material as described in Table 4 was molded and used, the same procedure as in Examples 2-(1) to 2-(4) was carried out to obtain a housing. The molding conditions and evaluation results in Example 9 are shown in Table 4 below.

### (Example 10)

Except that a bottom cover and a top cover each having a size as described in Table 4 were molded and used, the same procedure as in Examples 2- (1) to 2- (4) was carried out to obtain a housing. The molding conditions and evaluation results in Example 10 are shown in Table 4 below.

### (Examples 11 and 12)

Except that a reinforcing structure having a size as described in Table 4 was molded and used, the same procedure as in Examples 2-(1) to 2-(4) was carried out to obtain a housing. The molding conditions and evaluation results in Examples 11 and 12 are shown in Table 4 below.

### (Example 13)

### Example 13-(1): Preparation of Bottom Cover

A laminate obtained by laminating 10 sheets of material described in Table 5, a press molding apparatus, and a pair of molds 106 as shown in Fig. 12(a) were used. The laminate was disposed in a pair of molds 106. Here, the heating platen temperature of the press molding apparatus was set to 260°C, and the laminate was pressurized with the molding pressure kept at 1.0 MPa. After 10 minutes, cooling water was made to pass through the heating plate, so that cooling was started. After the mold temperature decreased to 100°C or lower, the molds 106 were opened, and a molded article was taken out from the molds 106. Trimming was performed so that the rising wall of the resulting molded article had a desired height, thereby obtaining a bottom cover.

### Example 13-(2): Preparation of Reinforcing Structure and Top Cover

Except that the mold to be used was changed so as to attain a size as described in Table 5, the same procedure as in Example 13-(1) was carried out to obtain a reinforcing structure and a top cover.

### Example 13-(3): Preparation of Housing

Except that the resulting bottom cover and reinforcing structure were used, the same procedure as in Example 1- (4) was carried out to join a bottom cover using an adhesive. The molding conditions and evaluation results in Example 13 are shown in Table 5 below.

### (Example 14)

### Examples 14-(1) and 14-(2) : Preparation of Bottom Cover and Top Cover

Each member was obtained in the same manner as in Examples 2-(1) and 2-(2).

### Example 14-(3): Preparation of Reinforcing Structure

Except that a mold corresponding to only a flat portion 31 of a reinforcing structure as shown in Fig. 2 was used, the same procedure as in Example 2-(3) was carried out to obtain a flat portion of a reinforcing structure. The flat portion of the resulting reinforcing structure was then inserted into an injection mold, and using a molding machine, a glass fiber-reinforced resin (CM1011G-30 manufactured by Toray Industries, Inc.) was molded at a cylinder temperature of 260°C and a mold temperature of 80°C to form a rising wall member 32 and a joining portion 33 of a reinforcing structure as shown in Fig. 2, thereby obtaining a reinforcing structure.

### Example 14-(4): Preparation of Housing

Except that each member obtained in Examples 14-(1) and 14-(3) was used, the same procedure as in Example 2-(4) was carried out to obtain an integrated product of a bottom cover 2 and a reinforcing structure 3. Similarly, the top cover obtained in Example 14-(2) was thermally welded and joined to the bottom cover. The molding conditions and evaluation results in Example 14 are shown in Table 5 below.

### (Example 15)

### Example 15-(1): Preparation of Bottom Cover

Except that a mold corresponding to only a flat portion 21 of a bottom cover as shown in Fig. 2 was used, the same procedure as in Example 2-(1) was carried out to obtain a flat portion of a bottom cover. The flat portion of the resulting bottom cover was then inserted into an injection mold, and using a molding machine, a carbon fiber-reinforced resin (TLP1060 manufactured by Toray Industries, Inc.) was molded at a cylinder temperature of 260°C and a mold temperature of 80°C to form a rising wall member 22 of a bottom cover as shown in Fig. 2, thereby obtaining a bottom cover.

### Examples 15-(2) and 15-(3): Preparation of Top Cover and Reinforcing Structure

Atop cover and a reinforcing structure were obtained in the same manner as in Examples 2-(2) and 2-(3).

### Example 15-(4): Preparation of Housing

Except that each member obtained in Examples 15-(1) and 15-(3) was used, the same procedure as in Example 2-(4) was carried out to obtain an integrated product of a bottom cover 2 and a reinforcing structure 3. Similarly, the top cover obtained in Example 15-(2) was thermally welded and joined to the bottom cover. The molding conditions and evaluation results in Example 15 are shown in Table 5 below.

### (Reference Example 1)

Except that a size as described in Table 5 was employed, the same procedure as in Example 2 was carried out to obtain a bottom cover and a reinforcing structure. An electronic component was disposed in a hollow structure formed by the bottom cover and the reinforcing structure and in a space formed by the bottom cover and a top cover, and the joining portions were joined by an ultrasonic welding machine. In addition, as a top cover, a liquid crystal display was provided, and joined to a bottom member by a double-sided tape. The molding conditions and evaluation results in the electronic device obtained in Reference Example 1 are shown in Table 5 below.

### (Comparative Example 1)

Except that members were joined using a double-sided tape, the same procedure as in Examples 1-(1) to 1-(4) was carried out to obtain a housing. The molding conditions and evaluation results in Comparative Example 1 are shown in Table 6 below.

### (Comparative Example 2)

Except that members were mechanically joined using a screw, the same procedure as in Examples 1-(1) to 1-(4) was carried out to obtain a housing. The molding conditions and evaluation results in Comparative Example 2 are shown in Table 6 below.

### (Comparative Example 3)

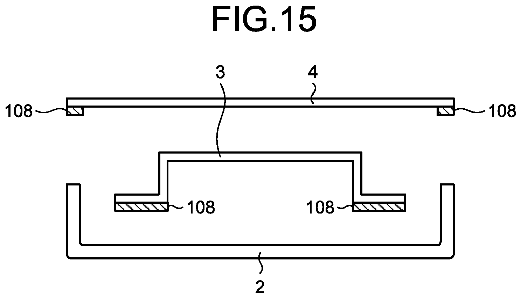

Except that members were joined using a an adhesive 108 as shown in Fig. 15, the same procedure as in Examples 1-(1) to 1-(4) was carried out to obtain a housing. The molding conditions and evaluation results in Comparative Example 3 are shown in Table 6 below.

### [Evaluation]

It was confirmed that the housings obtained in examples had high torsional rigidity and were easily disassembled. Thus, these housings were preferable from the viewpoint of repair and recycling while exhibiting high properties as a housing. Examples 2 and 13 are preferable from the viewpoint of weight reduction because the reinforcing structure and the bottom cover are bonded directly to each other, and therefore an increase in weight is smaller as compared to a case where an adhesive or a hot melt resin is used. It was confirmed that in Example 3, not only torsional rigidity but also deflection rigidity was exhibited due to the effect of another reinforcing structure. In Examples 4 to 13, higher torsional rigidity was exhibited because a reinforcing structure having a joining portion as shown in Fig. 3(c) was used.

In Examples 5 to 7, not only high torsional rigidity but also deflection rigidity was exhibited by using a metal material having high dynamic properties for the bottom cover. In addition, the metal material has a high thermal conductivity, and is therefore preferable from the viewpoint of thermal characteristics. Example 8 is preferable from the viewpoint of not only high torsional rigidity but also enabling radio wave communication because a non-conductive material having electromagnetic wave permeability is used for the bottom cover. In Example 9, higher torsional rigidity was exhibited because a fiber-reinforced composite material including a carbon fiber having high dynamic properties as a reinforcing fiber was used for the reinforcing structure. In addition, the housing is also superior in weight reduction to one in which a fiber-reinforced composite material including a glass fiber as a reinforcing fiber is used as a reinforcing material. Examples 10 and 11 are intended to reduce the thickness of each member, and thus contributes to weight reduction and thickness reduction of the housing while maintaining torsional rigidity. In Example 13, a resin material was used for each member, and it was confirmed that while having poor deflection rigidity, the housing exhibited torsional rigidity. In Examples 14 and 15, the rising wall member and the joining portion each having a complicated shape were formed of a fiber-reinforced resin excellent in moldability, and therefore excellent productivity was obtained while torsional rigidity was exhibited. In addition, Reference Example 1 was provided as a method for using a housing, where electronic components were disposed in a hollow structure to prepare an electronic device with a liquid crystal display used as a top cover. It was confirmed that when the requirements of the present invention were satisfied, it was possible to provide an electronic device exhibiting high torsional rigidity, deflection rigidity and disassembly property.

On the other hand, in Comparative Example 1, the reinforcing structure was peeled off from the bottom cover during evaluation of torsional rigidity, and thus a satisfactory housing was not obtained. The housings of Comparative Examples 2 and 3 were comparable in torsional rigidity and the like to the housing of the present invention. However, in Comparative Example 2, it was possible to easily disassemble the housing by a user, and in Comparative Example 3, it was impossible to disassemble the housing, but it was unable to easily disassemble the housing to perform repair and separation. Thus, the housings of Comparative Examples 2 and 3 did not meet requests from the market.

**[Table 2]**

| | | | Example 1 | Example 2 | Example 3 | Example 4 |
|---|---|---|---|---|---|---|
| Bottom cover: | | | | | | |
| | Material | - | Material 1 | Material 1 | Material 1 | Material 4 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 0.8 | 0.8 | 0.8 |
| | Projected area | cm² | 630 | 630 | 630 | 630 |
| | Volume | cm³ | 572 | 572 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 2 |
| | Length | mm | 200 | 200 | 200 | 200 |
| | Width | mm | 290 | 290 | 290 | 290 |
| | Height | mm | 8 | 8 | 8 | 8 |
| | Angle | ° | 90 | 90 | 90 | 90 |
| | Thickness | mm | 0.8 | 0.8 | 0.8 | 0.8 |
| | Overlap width | mm | 0 | 0 | 0 | 5 |
| | Bonding area | cm² | 8 | 8 | 8 | 8 |
| | Projected area | cm² | 580 | 580 | 580 | 580 |
| | Volume | cm³ | 412 | 412 | 412 | 412 |

| Another reinforcing structure | | | | | | |
|---|---|---|---|---|---|---|
| | Material | - | - | - | Material 1 | - |
| | Length | mm | - | - | 188 | - |
| | Width | mm | - | - | 3 | - |
| | Height | mm | - | - | 4 | - |

| Electronic device housing | | | | | | |
|---|---|---|---|---|---|---|
| | Projected area ratio | % | 92.1 | 92.1 | 92.1 | 92.1 |
| | Volume ratio | | 72.0 | 70.2 | 70.2 | 72.0 |
| | Integration method | - | Thermal welding | Thermal welding | Thermal welding | Thermal welding |
| | Bonding portion | - | Plane | Plane | Plane | Plane |
| | Peeling load (23°C) | N/cm² | 2000 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ⊙ | ⊙ | ⊙ | ⊙ |
| | Deflection rigidity | - | ○ | ○ | ⊙ | ○ |

**[Table 3]**

| | | | Example 5 | Example 6 | Example 7 | Example 8 |
|---|---|---|---|---|---|---|
| Bottom cover: | | | | | | |
| | Material | - | Material 3 | Material 4 | Material 5 | Material 2 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.6 | 0.8 | 0.2 | 0.8 |
| | Projected area | cm² | 630 | 630 | 630 | 630 |

| | Volume | cm³ | 572 | 572 | 615 | 572 |
|---|---|---|---|---|---|---|
| Top cover: | | | | | | |
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 2 |
| | Length | mm | 200 | 200 | 200 | 200 |
| | Width | mm | 290 | 290 | 290 | 290 |
| | Height | mm | 8 | 8 | 8 | 8 |
| | Angle | ° | 90 | 90 | 90 | 90 |
| | Thickness | mm | 0.8 | 0.8 | 0.8 | 0.8 |
| | Overlap width | mm | 5 | 5 | 5 | 5 |
| | Bonding area | cm² | 48 | 48 | 48 | 48 |
| | Projected area | cm² | 580 | 580 | 580 | 580 |
| | Volume | cm³ | 412 | 412 | 412 | 412 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 92.1 | 92.1 | 92.1 | 92.1 |
| | Volume ratio | % | 70.2 | 72.0 | 66.9 | 72.0 |
| | Integration method | - | Thermal welding | Thermal welding | Thermal welding | Thermal welding |
| | Bonding portion | - | Plane | Plane | Plane | Plane |
| | Peeling load (23°C) | N/cm² | 2500 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ⊙ | ○ | ○ | ○ |
| | Deflection rigidity | - | ○ | ○ | ○ | ○ |

**[Table 4]**

| | | | Example 9 | Example 10 | Example 11 | Example 12 |
|---|---|---|---|---|---|---|
| Bottom cover: | | | | | | |
| | Material | - | Material 1 | Material 1 | Material 1 | Material 1 |
| | Length | mm | 210 | 210 | 210 | 180 |
| | Width | mm | 300 | 300 | 300 | 300 |
| | Height | mm | 10 | 10 | 10 | 10 |
| | Thickness | mm | 0.8 | 0.4 | 0.8 | 0.8 |
| | Projected area | cm² | 630 | 630 | 630 | 630 |
| | Volume | cm³ | 572 | 601 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.6 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 1 | Material 2 | Material 2 | Material 2 |
| | Length | mm | 200 | 200 | 200 | 200 |
| | Width | mm | 290 | 290 | 290 | 290 |
| | Height | mm | 8 | 8 | 8 | 8 |
| | Angle | ° | 90 | 90 | 90 | 45 |
| | Thickness | mm | 0.8 | 0.8 | 0.4 | 0.8 |
| | Overlap width | mm | 5 | 5 | 5 | 5 |
| | Bonding area | cm² | 48 | 48 | 48 | 48 |
| | Projected area | cm² | 580 | 580 | 580 | 580 |
| | Volume | cm³ | 412 | 412 | 438 | 412 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 92.1 | 92.1 | 92.1 | 92.1 |
| | Volume ratio | % | 72.0 | 68.6 | 76.5 | 72.0 |
| | Integration method | | Thermal welding | Thermal welding | Thermal welding | Thermal welding |
| | Bonding portion | - | Plane | Plane | Plane | Plane |
| | Peeling load (23°C) | N/cm² | 2000 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ⊙ | ○ | ⊙ | ○ |
| | Deflection rigidity | - | ○ | ○ | ○ | ○ |

**[Table 5]**

| | | | Example 13 | Example 14 | Example 15 | Reference Example 1 |
|---|---|---|---|---|---|---|
| Bottom cover: | | | | | | |
| | Material | - | Material 6 | Material 1 | Material 1/CF-reinforced resin | Material 1 |
| | Length | mm | 210 | 210 | 210 | 180 |
| | Width | mm | 300 | 300 | 300 | 230 |
| | Height | mm | 10 | 10 | 10 | 7 |
| | Thickness | mm | 0.8 | 0.8 | 0.8 | 0.8 |
| | Projected area | cm² | 630 | 630 | 630 | 414 |
| | Volume | cm³ | 572 | 572 | 572 | 253 |

| Top cover: | | | | | | |
|---|---|---|---|---|---|---|
| | Material | - | Material 6 | Material 1 | Material 1 | Display |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 6 | Material 2/GF-reinforced resin | Material 2 | Material 2 |
| | Length | mm | 200 | 200 | 200 | 162 |
| | Width | mm | 290 | 290 | 290 | 215 |
| | Height | mm | 8 | 8 | 8 | 5 |
| | Angle | ° | 90 | 90 | 90 | 90 |
| | Thickness | mm | 0.8 | 0.8 | 0.8 | 0.5 |
| | Overlap width | mm | 5 | 0 | 0 | 5 |
| | Bonding area | cm² | 48 | 8 | 8 | 37 |
| | Projected area | cm² | 580 | 580 | 580 | 348.3 |
| | Volume | cm³ | 412 | 412 | 412 | 155 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 92. 1 | 92 .1 | 92.1 | 84.1 |
| | Volume ratio | % | 72.0 | 72.0 | 72.0 | 61.4 |
| | Integration method | - | Thermal welding | Thermal welding | Thermal welding | Thermal welding |
| | Bonding portion | - | Plane | Plane | Plane | Plane |
| | Peeling load (23°C) | N/cm² | 1500 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ○ | ⊙ | ⊙ | ⊙ |
| | Deflection rigidity | - | Δ | ○ | ○ | ○ |

**[Table 6]**

| | | | Comparati ve Example 1 | Comparativ e Example 2 | Comparativ e Example 3 |
|---|---|---|---|---|---|
| Bottom cover: | | | | | |
| | Material | - | Material 1 | Material 1 | Material 1 |
| | Length | mm | 210 | 210 | 210 |
| | Width | mm | 300 | 300 | 300 |
| | Height | mm | 10 | 10 | 10 |
| | Thickness | mm | 0.8 | 0.8 | 0.8 |
| | Projected area | cm² | 630 | 630 | 630 |
| | Volume | cm³ | 572 | 572 | 572 |

| Top cover: | | | | | |
|---|---|---|---|---|---|
| | Material | - | Material | Material 1 | Material 1 |
| | Length | mm | 210 | 210 | 210 |
| | Width | mm | 300 | 300 | 300 |
| | Height | mm | - | - | - |
| | Thickness | mm | 0.8 | 0.8 | 0.8 |
| | Projected area | cm² | 630 | 630 | 630 |
| | Volume | cm³ | - | - | - |

| Reinforcing structure: | | | | | |
|---|---|---|---|---|---|
| | Material | - | Material 2 | Material 2 | Material 2 |
| | Length | mm | 200 | 200 | 200 |
| | Width | mm | 290 | 290 | 290 |
| | Height | mm | 8 | 8 | 8 |
| | Angle | ° | 90 | 90 | 90 |
| | Thickness | mm | 0.8 | 0.8 | 0.8 |
| | Overlap width | mm | 5 | 5 | 5 |
| | Bonding area | cm² | 48 | 48 | 48 |
| | Projected area | cm² | 580 | 580 | 580 |
| | Volume | cm³ | 412 | 412 | 412 |

| Another -reinforcing structure | | | | | |
|---|---|---|---|---|---|
| | Material | - | - | - | - |
| | Length | mm | - | - | - |
| | Width | mm | - | - | - |
| | Height | mm | - | - | - |

| Electronic device housing | | | | | |
|---|---|---|---|---|---|
| | Projected area ratio | % | 92.1 | 92.1 | 92.1 |
| | Volume ratio | % | 72.0 | 72.0 | 72.0 |
| | Integratio n method | - | Double-si ded tape | Mechanical joining | Adhesive |
| | Bonding portion | - | Plane | Plane | Plane |
| | Peeling load (23°C) | N/cm² | 300 | 4000 | 1500 |
| | Peeling load (200°C) | N/cm² | 50 | 4000 | 700 |

| Evaluation | | | | | |
|---|---|---|---|---|---|
| | Torsional rigidity | - | × | ⊙ | ⊙ |
| | Deflectio n rigidity | - | × | ○ | ○ |

### INDUSTRIAL APPLICABILITY

According to the present invention, there can be provided a housing which makes it difficult to access electronic components by a user, can be easily disassembled in the case of requiring repair and separation, and has improved torsional rigidity and productivity while having a reduced thickness and weight.

### DESCRIPTION OF REFERENCE SIGNS

- 1:: Housing
- 2:: Bottom cover
- 3:: Reinforcing structure
- 4:: Top cover
- 5:: Another reinforcing structure
- 21:: Flat portion
- 22:: Rising wall member
- 31:: Flat portion
- 32:: Rising wall member
- 33:: Joining portion

## Claims

1. A housing (1) comprising: a top cover (4); a bottom cover (2); and a reinforcing structure (3) that is disposed in a space divided by the top cover (4) and the bottom cover (2), and has an opening, the reinforcing structure (3) being joined to the top cover (4) or the bottom cover (2),
**characterized in that**
the reinforcing structure (3) is joined to the bottom cover (4) or the top cover (2) with a peeling load of 60 N/cm² or more and 5000 N/cm² or less at 23°C and with a peeling load of less than 60 N/cm² at 200°C.

2. The housing (1) according to claim 1,, wherein the reinforcing structure (3) is (2) joined to the top cover (4) or the bottom cover (2) by thermal welding.

3. The housing (1) according to claim 1 or 2,
wherein a thermoplastic resin is provided in or on a joining portion (33) of at least one of the reinforcing structure (3) and the top cover (4) or the bottom cover (2) to which the reinforcing structure (3) is joined, and the reinforcing structure (3) and the top cover (4) or the bottom cover (2) are joined with the thermoplastic resin.

4. The housing (1) according to any one of claims 1 to 3,
wherein the reinforcing structure (3), and the top cover (4) or the bottom cover (2) to which the reinforcing structure (3) is joined are formed of a fiber-reinforced composite material that is a cured product of a laminate of prepregs including a reinforcing fiber and a matrix resin.

5. The housing (1) according to any one of claims 1 to 4, wherein the reinforcing structure (3) is joined directly to the top cover (4) or the bottom cover (2).

6. The housing (1) according to claim 4, wherein the matrix resin includes a thermosetting resin.

7. The housing (1) according to any one of claims 1 to 6,
wherein the reinforcing structure (3) includes at least one material selected from the group consisting of a metal, a fiber-reinforced composite material with a glass fiber used as a reinforcing fiber, and a fiber-reinforced composite material with a carbon fiber used as a reinforcing fiber, and the top cover (4) or the bottom cover (2) which is joined to the reinforcing structure (3) includes at least one material that is selected from the group, and is different from the material of the reinforcing structure (3).

8. The housing (1) according to any one of claims 1 to 7,
wherein at least a part of the bottom cover (2) or the top cover (4) which is joined to the reinforcing structure (3) includes a material having a volume resistivity of less than 1.0 × 10⁻² Ω•m, and the reinforcing structure (3) includes a material having a volume resistivity of 1.0 × 10⁻² Ω•m or more.

9. The housing (1) according to any one of claims 1 to 8, wherein the reinforcing structure (3) includes a plurality of components.

10. The housing (1) according to any one of claims 1 to 9, wherein the top cover (4) and/or the bottom cover (2) includes a plurality of components.

## Patentansprüche

1. Gehäuse (1), umfassend: eine obere Abdeckung (4); eine untere Abdeckung (2); und eine Verstärkungsstruktur (3), die in einem durch die obere Abdeckung (4) und die untere Abdeckung (2) unterteilten Raum angeordnet ist und eine Öffnung aufweist, wobei die Verstärkungsstruktur (3) mit der oberen Abdeckung (4) oder der unteren Abdeckung (2) verbunden ist,
**dadurch gekennzeichnet, dass** die Verstärkungsstruktur (3) mit der unteren Abdeckung (4) oder der oberen Abdeckung (2) mit einer Schälbelastung von 60 N/cm² oder mehr und 5000 N/cm² oder weniger bei 23 °C und mit einer Schälbelastung von weniger als 60 N/cm² bei 200 °C verbunden ist.

2. Gehäuse (1) nach Anspruch 1, wobei die Verstärkungsstruktur (3) mit der oberen Abdeckung (4) oder der unteren Abdeckung (2) durch thermisches Schweißen verbunden ist.

3. Gehäuse (1) nach Anspruch 1 oder 2,
wobei ein thermoplastisches Harz in oder an einem Verbindungsabschnitt (33) von zumindest einem von der Verstärkungsstruktur (3) und der oberen Abdeckung (4) oder der unteren Abdeckung (2), mit der die Verstärkungsstruktur (3) verbunden ist, vorgesehen ist, und die Verstärkungsstruktur (3) und die obere Abdeckung (4) oder die untere Abdeckung (2) mit dem thermoplastischen Harz verbunden sind.

4. Gehäuse (1) nach einem der Ansprüche 1 bis 3,
wobei die Verstärkungsstruktur (3) und die obere Abdeckung (4) oder die untere Abdeckung (2), mit der die Verstärkungsstruktur (3) verbunden ist, aus einem faserverstärkten Verbundmaterial gebildet sind, das ein ausgehärtetes Produkt eines Laminats von Prepregs ist, die eine Verstärkungsfaser und ein Matrixharz beinhalten.

5. Gehäuse (1) nach einem der Ansprüche 1 bis 4, wobei die Verstärkungsstruktur (3) direkt mit der oberen Abdeckung (4) oder der unteren Abdeckung (2) verbunden ist.

6. Gehäuse (1) nach Anspruch 4, wobei das Matrixharz ein wärmehärtendes Harz beinhaltet.

7. Gehäuse (1) nach einem der Ansprüche 1 bis 6,
wobei die Verstärkungsstruktur (3) zumindest ein Material beinhaltet, das aus der Gruppe ausgewählt ist, die aus einem Metall, einem faserverstärkten Verbundmaterial mit einer Glasfaser, die als Verstärkungsfaser verwendet wird, und einem faserverstärkten Verbundmaterial mit einer Kohlefaser, die als Verstärkungsfaser verwendet wird, besteht, und die obere Abdeckung (4) oder die untere Abdeckung (2), die mit der Verstärkungsstruktur (3) verbunden ist, zumindest ein Material beinhaltet, das aus der Gruppe ausgewählt ist und sich von dem Material der Verstärkungsstruktur (3) unterscheidet.

8. Gehäuse (1) nach einem der Ansprüche 1 bis 7,
wobei zumindest ein Teil der unteren Abdeckung (2) oder der oberen Abdeckung (4), die mit der Verstärkungsstruktur (3) verbunden ist, ein Material beinhaltet, das einen spezifischen Volumenwiderstand von weniger als 1,0 × 10⁻² Ω•m aufweist, und die Verstärkungsstruktur (3) ein Material beinhaltet, das einen spezifischen Volumenwiderstand von 1,0 × 10⁻² Ω•m oder mehr aufweist.

9. Gehäuse (1) nach einem der Ansprüche 1 bis 8, wobei die Verstärkungsstruktur (3) eine Vielzahl von Komponenten beinhaltet.

10. Gehäuse (1) nach einem der Ansprüche 1 bis 9, wobei die obere Abdeckung (4) und/oder die untere Abdeckung (2) eine Vielzahl von Komponenten beinhalten.

## Revendications

1. Boîtier (1) comprenant : un couvercle supérieur (4) ; un couvercle inférieur (2) ; et une structure de renforcement (3) qui est disposée dans un espace divisé par le couvercle supérieur (4) et le couvercle inférieur (2), et a une ouverture, la structure de renforcement (3) étant assemblée au couvercle supérieur (4) ou au couvercle inférieur (2),
**caractérisé en ce que** :
la structure de renforcement (3) est assemblée au couvercle inférieur (4) ou au couvercle supérieur (2) par une charge de détachement de 60 N/cm² ou supérieure et 5000 N/cm² ou inférieure à 23°C et avec une charge de détachement inférieure à 60 N/cm² à 200°C.

2. Boîtier (1) selon la revendication 1, dans lequel la structure de renforcement (3) est (2) assemblée au couvercle supérieur (4) ou au couvercle inférieur (2) par soudage thermique.

3. Boîtier (1) selon la revendication 1 ou 2,
dans lequel une résine thermoplastique est prévue dans ou sur une partie d'assemblage (33) d'au moins l'un parmi la structure de renforcement (3) et le couvercle supérieur (4) ou le couvercle inférieur (2) auquel la structure de renforcement (3) est assemblée, et la structure de renforcement (3) et le couvercle supérieur (4) ou le couvercle inférieur (2) sont assemblés avec la résine thermoplastique.

4. Boîtier (1) selon l'une quelconque des revendications 1 à 3,
dans lequel la structure de renforcement (3) et le couvercle supérieur (4) ou le couvercle inférieur (2) auquel la structure de renforcement (3) est assemblée, sont formés avec un matériau composite renforcé en fibre qui est un produit durci d'un stratifié de préimprégnés comprenant une fibre de renforcement et une résine matricielle.

5. Boîtier (1) selon l'une quelconque des revendications 1 à 4, dans lequel la structure de renforcement (3) est assemblée directement au couvercle supérieur (4) ou au couvercle inférieur (2).

6. Boîtier (1) selon la revendication 4, dans lequel la résine matricielle comprend une résine thermodurcissable.

7. Boîtier (1) selon l'une quelconque des revendications 1 à 6,
dans lequel la structure de renforcement (3) comprend au moins un matériau sélectionné dans le groupe comprenant un métal, un matériau composite renforcé en fibre avec une fibre de verre utilisée en tant que fibre de renforcement, et un matériau composite renforcé en fibre avec une fibre de carbone utilisée en tant que fibre de renforcement, et le couvercle supérieur (4) ou le couvercle inférieur (2) qui est assemblé à la structure de renforcement (3), comprend au moins un matériau qui est sélectionné dans le groupe, et est différent du matériau de la structure de renforcement (3).

8. Boîtier (1) selon l'une quelconque des revendications 1 à 7,
dans lequel au moins une partie du couvercle inférieur (2) et du couvercle supérieur (4) qui est assemblée à la structure de renforcement (3), comprend un matériau ayant une résistivité volumique inférieure à 1,0 x 10⁻² Ω.m, et la structure de renforcement (3) comprend un matériau ayant une résistivité volumique de 1,0 x 10⁻² Ω.m ou plus.

9. Boîtier (1) selon l'une quelconque des revendications 1 à 8, dans lequel la structure de renforcement (3) comprend une pluralité de composants.

10. Boîtier (1) selon l'une quelconque des revendications 1 à 9, dans lequel le couvercle supérieur (4) et/ou le couvercle inférieur (2) comprend une pluralité de composants.
